# EUROPÄISCHE PATENTSCHRIFT

(11) **EP 2 072 456 B1**
(45) Veröffentlichungstag und Bekanntmachung des Hinweises auf die Patenterteilung: **15.07.2015**
(21) Anmeldenummer: 08105774.7
(22) Anmeldetag: 12.11.2008
(51) Int. Cl.: B81B 3/00

(54) **Mikromechanisches Bauelement mit reduzierter Spannung in der Membranstruktur**
Micromechanical element with reduced stress in the membrane structure
Elément micromécanique avec une tension mécanique réduite dans la membrane

(30) Priorität: 20.12.2007 DE 102007061727
(43) Veröffentlichungstag der Anmeldung: 24.06.2009
(73) Patentinhaber: ROBERT BOSCH GMBH, 70442 Stuttgart (DE)
(72) Erfinder: Benzel, Hubert, 72124, Pliezhausen (DE); Schelling, Christoph, 70597, Stuttgart (DE)

(56) Entgegenhaltungen:
- DE-A1-102006 022 379
- CATTIN D ET AL: "Modelling and control of IRST MEMS microphone", ADVANCED MOTION CONTROL, 2006. 9TH IEEE INTERNATIONAL WORKSHOP ON MARCH 2006, PISCATAWAY, NJ, USA,IEEE, 1. März 2006 (2006-03-01), Seiten 512-516, XP010918229, DOI: 10.1109/AMC.2006.1631712 ISBN: 978-0-7803-9511-4

## Beschreibung

### Stand der Technik

Die Erfindung betrifft ein mikromechanisches Bauelement mit einem Substrat und einem Schichtaufbau auf dem Substrat. Dieser Schichtaufbau umfasst eine Membran, die mindestens einen Hohlraum im Substrat überspannt, und eine starre Deckschicht, die über der Membran und beabstandet zu dieser angeordnet ist und mindestens eine Zugangsöffnung zur Membran aufweist, so dass die Membran über die Zugangsöffnung mit Druck beaufschlagbar ist und senkrecht zu den Schichtebenen elastisch auslenkbar ist. Außerdem ist im Schichtaufbau der Membran mindestens ein Schaltungselement zum Erfassen von Membranauslenkungen als Bestandteil einer Auswerteschaltung ausgebildet.

Die deutsche Patentanmeldung DE 10 2007 019639.5 hat ein solches mikromechanisches Bauelement zum Gegenstand. Hier wird ein Sensorelement zur kapazitiven Druckerfassung beschrieben, das mit Verfahren der Oberflächenmikromechanik gefertigt wird. Der Aufbau des Sensorelements umfasst ein Siliziumsubstrat, in dessen Oberfläche ein Hohlraum ausgebildet ist, und eine Membran, die den Hohlraum überspannt und in einem Schichtaufbau über dem Substrat ausgebildet ist. Als erste Schicht dieses Schichtaufbaus ist eine leitfähige monokristalline Siliziumschicht auf der Substratoberfläche abgeschieden worden. Des Weiteren umfasst der Schichtaufbau eine Leiterbahnebene aus Poly-Silizium, die durch eine Siliziumoxid-Schicht gegen die erste monokristalline Siliziumschicht elektrisch isoliert ist. Auf der Leiterbahnebene ist eine zweite Isolationsschicht aus z.B. Siliziumnitrid abgeschieden, die die Oberfläche der Membran bildet. Über der Membran und mit Abstand zu dieser ist schließlich noch eine starre Deckschicht aus Poly-Silizium angeordnet, in der Zugangsöffnungen zur Druckbeaufschlagung der Membran ausgebildet sind. Bei Druckeinwirkung wird die Membran elastisch ausgelenkt, was mit Hilfe eines Messkondensators erfasst wird. Die bewegliche Elektrode dieses Messkondensators ist in der Leiterbahnebene des Schichtaufbaus der Membran ausgebildet, während die starre Gegenelektrode des Messkondensators im gegenüberliegenden Bereich der starren Deckschicht realisiert ist.

Es ist davon auszugehen, dass in der Membranstruktur des in der DE 10 2007 019639.5 beschriebenen Sensorelements auch im Ruhezustand mechanische Spannungen auftreten. Diese sind einerseits herstellungsbedingt und auf den Schichtaufbau der Membran zurückzuführen und andererseits dadurch bedingt, dass in der Umgebung des Sensorelements in der Regel andere Druckverhältnisse herrschen als in dem abgeschlossenen Hohlraum unter der Membran. Derartige mechanische Spannungen in der Membranstruktur beeinträchtigen die Messempfindlichkeit des Sensorelements und wirken sich letztlich auch negativ auf die Signalgüte aus.

### Offenbarung der Erfindung

Mit der vorliegenden Erfindung wird vorgeschlagen, mechanische Spannungen in der Membranstruktur eines mikromechanischen Bauelements der eingangs genannten Art mit Hilfe einer Kompensationsschaltung zu reduzieren.

Grundsätzlich gibt es verschiedene Möglichkeiten für die Realisierung einer solchen Kompensationsschaltung, die aber in jedem Fall mindestens ein Aktuatorelement umfassen muss, d.h. ein Schaltungselement zum mechanischen Einwirken auf die Membranstruktur. Erfindungsgemäss handelt es sich dabei um ein Piezoelement, das im Schichtaufbau der Membran ausgebildet ist. Alternativ kann die Vorauslenkung der Membran auch vorteilhaft durch Anlegen einer elektrischen Spannung zwischen der Membran bzw. einer im Schichtaufbau der Membran ausgebildeten Kondensatorelektrode und einer feststehenden Gegenelektrode kompensiert werden, die oberhalb der Membran, an der starren Deckschicht angeordnet sein kann.

Diese Alternative ist jedoch nicht Bestandteil der Erfindung.

In einer vorteilhaften Ausführungsform der Erfindung wird das Aktuatorelement, also ein Piezoelement, auch zur Messwerterfassung genutzt.

Im Hinblick auf eine möglichst weitgehende Kompensation von mechanischen Spannungen innerhalb der Membranstruktur ist es von Vorteil, wenn die Kompensationsschaltung mindestens ein Schaltungselement umfasst, mit dem eine Vorauslenkung der Membran auch quantitativ erfasst wird. Dabei könnte es sich beispielsweise um Piezoelemente handeln, die am Membranrand integriert sind. Die so gewonnenen Messwerte könnten dann beispielsweise einer Regelung der an einen Kompensationskondensator angelegten Spannung zugrunde gelegt werden.

In einer bevorzugten Variante des erfindungsgemäßen Bauelements handelt es sich bei der ersten Schicht des Schichtaufbaus um eine monokristalline Halbleiterschicht, die den Hohlraum besonders gut abdichtet und zudem eine hohe Bruch- und Rissstabilität der Membran gewährleistet. Außerdem lassen sich einfach Teile der Auswerteschaltung und/oder der Kompensationsschaltung in eine solche Schicht integrieren, was sich im Hinblick auf eine Miniaturisierung als vorteilhaft erweist.

Zur Verringerung von Streukapazitäten werden die als Aktuator oder Signalgeber fungierenden Schaltungselemente, wie beispielsweise ein Piezoelement oder eine Kondensatorelektrode, vorteilhafterweise in einer zusätzlichen Leiterbahnebene im Schichtaufbau der Membran ausgebildet.

Wie bereits erwähnt, umfasst der Schichtaufbau des erfindungsgemäßen Bauelements eine starre Deckschicht, die über der Membran und beabstandet zu dieser angeordnet ist und mindestens eine Zugangsöffnung zur Membran aufweist. Diese Deckschicht bildet einen mechanischen Schutz für die Membran, indem sie die Membran gegen äußere Einwirkungen und Verschmutzung schützt. Je nach Abstand zur Membran, kann die starre Deckschicht zusätzlich auch als Überlastschutz fungieren.

In einer besonders vorteilhaften Ausführungsform des erfindungsgemäßen Bauelements sind außerdem Teile der Auswerteschaltung und/oder der Kompensationsschaltung in der starren Deckschicht integriert, die dazu aus einem leitfähigen Halbleitermaterial gebildet ist. Bei kapazitiver Signalerfassung dient die starre Deckschicht zudem vorteilhafterweise als Träger für die starre Gegenelektrode des Messkondensators.

Das erfindungsgemäße Bauelement kann als Sensorelement eines Absolutdrucksensors konzipiert sein oder als Δ-Drucksensor zum Erfassen kleiner relativer Druckänderungen.

Besonders vorteilhaft ist aber auch die Verwendung eines erfindungsgemäßen Bauelements im Rahmen eines Absolutdruckmikrofons.

Aus dem Stand der Technik sind kapazitiv arbeitende mikromechanische Mikrofonbauelemente bekannt. Die Membran dieser Bauelemente ist in einem Schichtaufbau über einem Substrat realisiert und überspannt eine Kaverne im Substrat, die allerdings über eine Öffnung an die Rückseite des Substrats angeschlossen ist. Diese offene Kaverne wird als Rückvolumen benötigt, das dazu dient, eine Phasenverschiebung zwischen der einfallenden und der reflektierten Welle zu erzeugen. Die Phasenverschiebung sorgt für den Differenzdruck, der die Mikrofonmembran auslenkt. Bedingt durch die natürlichen geometrischen Verhältnisse (Schallwellenlänge: λ_{Schall}∼0,1-10m ↔ Größe des Rückvolumens im Gehäuse: 0,001m) kommen dabei jedoch nur äußerst geringe Phasenverschiebungen (um 0,05°) bzw. Differenzdrücke zustande. Gleichzeitig kommt es durch die Trägheit der hinter der Membran befindlichen Luft zu einer Dämpfung des Signals.

Aufgrund der Kompensation von mechanischen Spannungen in der Membran des erfindungsgemäßen Bauelements kann dieses auch ohne Rückvolumen als Mikrofon eingesetzt werden. Dazu wird der im Hohlraum herrschende Druck vorteilhafterweise im Bereich zwischen einem Unterdruck und einem guten Vakuum eingestellt. Da das Vakuum keine Trägheit besitzt, entfällt etwa die Hälfte der Dämpfung. Außerdem entsteht hinter der Membran keine reflektierte Welle, die der einfallenden mit geringer Phasenverschiebung entgegenläuft. Deshalb steht der volle Schalldruck für das Signal zur Verfügung.

Ohne die erfindungsgemäße Kompensation von mechanischen Spannungen in der Membran würde der herrschende Absolutdruck zu einer Vorauslenkung der druckempfindlichen Membran führen, was eine mechanische Zugspannung innerhalb der Membranstruktur zur Folge hätte. Dadurch würde die Membran unempfindlicher gegen den Schalldruck und außerdem wäre die Empfindlichkeit der Membran auch abhängig vom herrschenden Absolutdruck.

Das erfindungsgemäße Bauelement eignet sich besonders für Anwendungen, die eine niedrige Leistungsaufnahme erfordern, wie mobile Anwendungen, und/oder für Anwendungen, bei denen sowohl ein Mikrofon als auch ein Drucksensor zum Einsatz kommen, wie beispielsweise in Navigationssystemen mit Sprachsteuerung und 3D-Höhenortung, Handys mit Höhenmesser oder PDAs mit Wetterstation und Sprachaufnahme bzw. - aufzeichnung. In diesen Fällen wird nur ein Sensorelement benötigt, was sehr platzsparend ist.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die dem unabhängigen Patentanspruch 1 nachgeordneten Patentansprüche und andererseits auf die nachfolgende Beschreibung eines Ausführungsbeispiels der Erfindung anhand der Zeichnungen verwiesen.
- **Fig. 1**: zeigt eine schematische Draufsicht auf den sensorischen Bereich eines erfindungsgemäßen Bauelements,
- **Fig. 2**: zeigt einen ersten Querschnitt durch dieses Bauelement entlang der Schnittebene A-A', und
- **Fig. 3**: zeigt einen zweiten Querschnitt durch dieses Bauelement entlang der Schnittebene B-B'.

### Ausführungsform der Erfindung

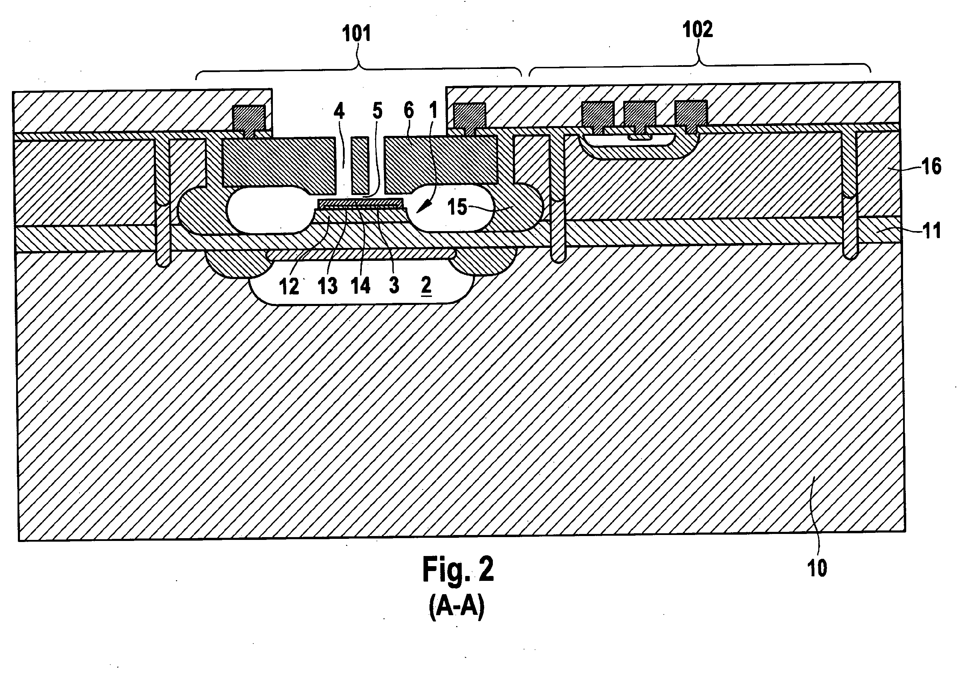

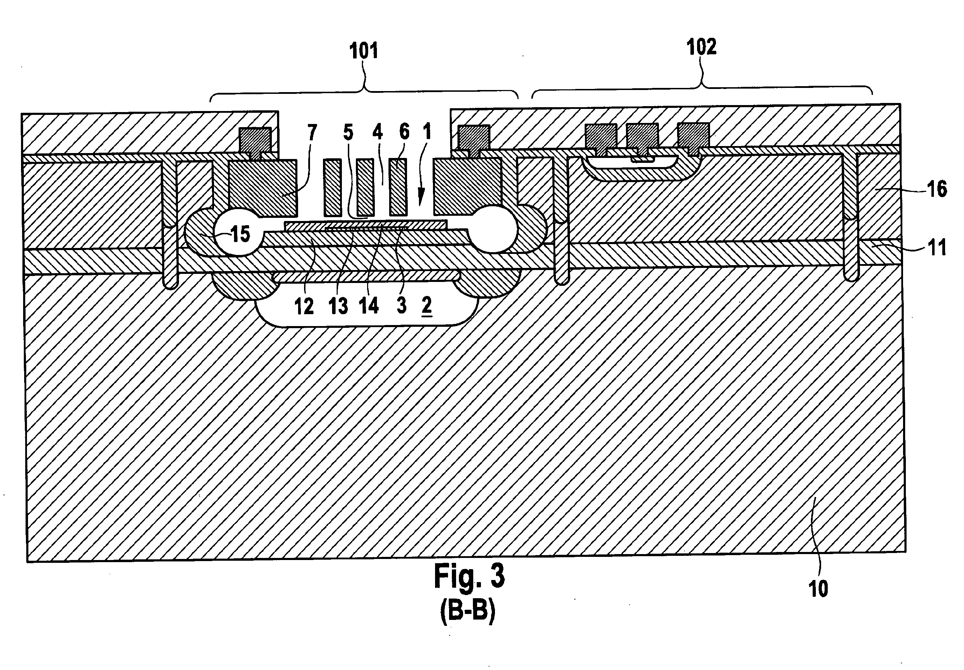

Bei dem in den Figuren dargestellten mikromechanischen Bauelement 100 handelt es sich um ein kapazitiv arbeitendes Mikrofon-Bauelement. Das Bauelement 100 ist ausgehend von einem p-dotierten Siliziumsubstrat 10 in einem Schichtaufbau realisiert, was insbesondere durch die Figuren 2 und 3 veranschaulicht wird. In diesem Schichtaufbau ist eine Membran 1 als sensitives Element ausgebildet, die einen Hohlraum 2 im Substrat 10 überspannt und abschließt. Der Schichtaufbau umfasst als erste Schicht 11 über dem Substrat 10 eine monokristalline Silizium-Epitaxieschicht. Im Membranbereich befindet sich auf der ersten Schicht 11 eine erste Isolationsschicht 12, die beispielsweise aus Siliziumoxid gebildet sein kann. Die kapazitive Signalerfassung erfolgt hier mit Hilfe einer Messelektrode 3, die in einer Leiterbahnebene 13 auf der Isolationsschicht 12 realisiert ist und so gegen die erste Schicht 11 elektrisch isoliert ist. Als Leiterbahnebene 13 fungiert hier eine Polysiliziumschicht. Die Messelektrode 3 wird von einer Siliziumnitrid-Passivierung 14 überdeckt. Diese zweite Isolationsschicht 14 bildet die Oberflächenschicht der Membran 1.

Die Membran 1 umgebend wurde in der Oberfläche der ersten Schicht 11 eine elektrisch isolierende LOCOS-Verdickung 15 erzeugt, die das Aufwachsen einer dicken Polysiliziumschicht 16 auf der ersten Schicht 11 als starre Deckschicht 16 über dem Schichtaufbau der Membran 1 ermöglichte. Durch Strukturierung der Deckschicht 16 wurden Zugangsöffnungen 4 geschaffen, über die auch ein Hohlraum 5 zwischen der Membran 1 und der Deckschicht 16 erzeugt wurde. Über die Zugangsöffnungen 4 kann der Schalldruck auf die Membran 1 einwirken, was dann Membranauslenkungen senkrecht zu den Schichtebenen zur Folge hat.

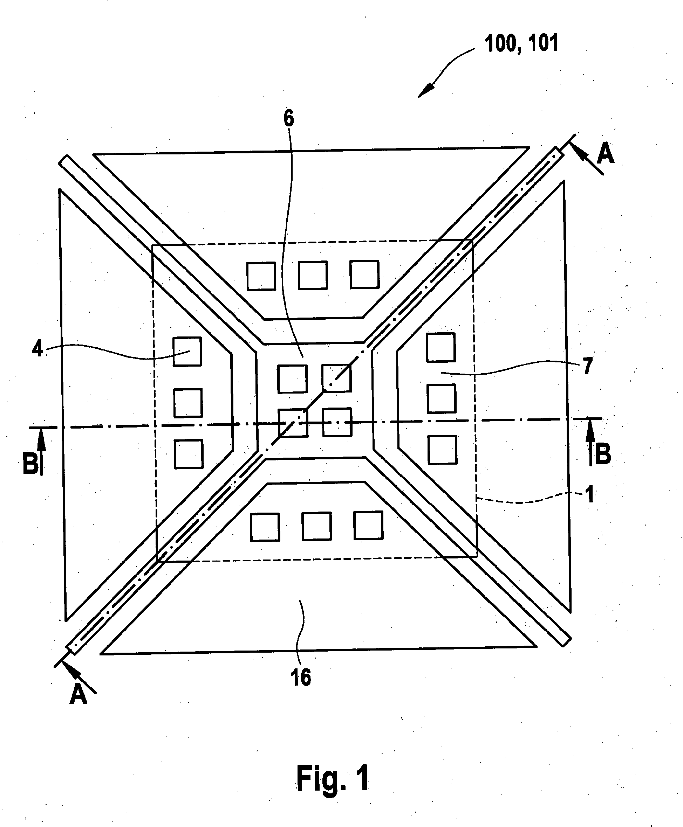

Fig. 1 veranschaulicht, dass der über der quadratischen Membran 1 befindliche Bereich der starren Deckschicht 16 durch die Strukturierung außerdem in fünf Segmente aufgeteilt worden ist, nämlich ein Mittelsegment 6 und vier Randsegmente 7. Das Mittelsegment 6 ist oberhalb der Membranmitte angeordnet und fungiert als starre Gegenelektrode 6 zu der mit der Membran 1 beweglichen Messelektrode 3. Die vier Randsegmente 7 dienen als Hilfselektroden 7 zur Einstellung des Arbeitspunkts. Durch Anlegen einer geeigneten Spannung zwischen der Messelektrode 3 und den Hilfselektroden 7 lassen sich herstellungsbedingte und druckbedingte mechanische Spannungen in der Membran 1 einfach kompensieren.

Erfindungsgemäß wird jedoch hiervon abweichend mindestens ein im Schichtaufbau der Membran ausgebildetes Piezoelement als Aktuatorelement vorgesehen.

Das Bauelement 100 umfasst außer dem voranstehend beschriebenen sensorischen Bereich 101 auch einen Schaltungsbereich 102, der in dem nicht strukturierten Oberflächenbereich der Deckschicht 16 angeordnet ist. Hier können Teile einer Auswerteschaltung zur Verarbeitung der Messsignale realisiert sein und auch Teile einer Kompensationsschaltung zur Spannungsregelung an den Hilfselektroden 7.

## Patentansprüche

1. Mikromechanisches Bauelement mit einem Substrat (10) und einem Schichtaufbau auf dem Substrat (10), mindestens umfassend
- eine Membran (1), die mindestens einen Hohlraum (2) im Substrat (10) überspannt, und
- eine starre Deckschicht (16), die über der Membran (1) und beabstandet zu dieser angeordnet ist und mindestens eine Zugangsöffnung (4) zur Membran (1) aufweist, so dass die Membran (1) über die Zugangsöffnung (4) mit Druck beaufschlagbar ist und senkrecht zu den Schichtebenen elastisch auslenkbar ist,
wobei
• im Schichtaufbau der Membran (1) mindestens ein Schaltungselement (3) zum Erfassen von Membranauslenkungen ausgebildet ist, und
• eine Kompensationsschaltung mit mindestens einem Aktuatorelement (3, 7) zur Kompensation von mechanischen Spannungen in der Membran vorgesehen ist,
**dadurch gekennzeichnet, dass**
die Kompensationsschaltung mindestens ein im Schichtaufbau der Membran ausgebildetes Piezoelement als Aktuatorelement umfasst.

2. Bauelement nach Anspruch 1, **dadurch gekennzeichnet, dass** das mindestens eine Aktuatorelement (3) auch zum Erfassen der Membranauslenkungen im Rahmen der Messwerterfassung vorgesehen ist.

3. Bauelement nach einem der Ansprüche 1 bis 2, **dadurch gekennzeichnet, dass** die Kompensationsschaltung mindestens ein Schaltungselement umfasst, mit dem eine Vorauslenkung der Membran quantitativ erfasst wird.

4. Bauelement nach einem der Ansprüche 1 bis 3, **dadurch gekennzeichnet, dass** der Schichtaufbau eine erste leitfähige Schicht (11) aus einem monokristallinen Halbleitermaterial umfasst und dass in dieser ersten leitfähigen Schicht zumindest Teile der Auswerteschaltung und/oder der Kompensationsschaltung integriert sind.

5. Bauelement nach einem der Ansprüche 1 bis 4, **dadurch gekennzeichnet, dass** der Schichtaufbau der Membran mindestens eine Leiterbahnebene (13) umfasst.

6. Bauelement nach Anspruch 5, **dadurch gekennzeichnet, dass** das mindestens eine Piezoelement oder die mindestens eine Kondensatorelektrode (3) in der Leiterbahnebene (13) ausgebildet ist.

7. Bauelement nach einem der Ansprüche 1 bis 6, **dadurch gekennzeichnet, dass** die starre Deckschicht (16) aus einem leitfähigen Halbleitermaterial gebildet ist.

8. Bauelement nach einem der Ansprüche 1 bis 7, **dadurch gekennzeichnet, dass** in der starren Deckschicht (16) zumindest Teile der Auswerteschaltung und/oder Kompensationsschaltung integriert sind.

9. Verwendung eines mikromechanischen Bauelements nach einem der Ansprüche 1 bis 8 als Sensorelement eines Absolutdrucksensors.

10. Verwendung eines mikromechanischen Bauelements nach einem der Ansprüche 1 bis 8 im Rahmen eines Absolutdruckmikrofons.

## Claims

1. Micromechanical component having a substrate (10) and a layer construction on the substrate (10), at least comprising
- a membrane (1) spanning at least one cavity (2) in the substrate (10), and
- a rigid covering layer (16), which is arranged above the membrane (1) and at a distance therefrom and has at least one access opening (4) to the membrane (1), such that pressure can be applied to the membrane (1) via the access opening (4) and said membrane is elastically deflectable perpendicularly to the layer planes,
wherein
• at least one circuit element (3) for detecting membrane deflections is formed in the layer construction of the membrane (1), and
• a compensation circuit having at least one actuator element (3, 7) is provided for compensating for mechanical stresses in the membrane,
**characterized in that**
the compensation circuit comprises at least one piezo element formed in the layer construction of the membrane as actuator element.

2. Component according to Claim 1, **characterized in that** the at least one actuator element (3) is also provided for detecting the membrane deflections in the context of the measurement value detection.

3. Component according to either of Claims 1 and 2, **characterized in that** the compensation circuit comprises at least one circuit element with which a predeflection of the membrane is quantitatively detected.

4. Component according to any of Claims 1 to 3, **characterized in that** the layer construction comprises a first conductive layer (11) composed of a monocrystalline semiconductor material, and **in that** at least parts of the evaluation circuit and/or of the compensation circuit are integrated in said first conductive layer.

5. Component according to any of Claims 1 to 4, **characterized in that** the layer construction of the membrane comprises at least one conductor track plane (13).

6. Component according to Claim 5, **characterized in that** the at least one piezo element or the at least one capacitor electrode (3) is formed in the conductor track plane (13).

7. Component according to any of Claims 1 to 6, **characterized in that** the rigid covering layer (16) is formed from a conductive semiconductor material.

8. Component according any of Claims 1 to 7, **characterized in that** at least parts of the evaluation circuit and/or compensation circuit are integrated in the rigid covering layer (16).

9. Use of a micromechanical component according to any of Claims 1 to 8 as sensor element of an absolute pressure sensor.

10. Use of a micromechanical component according to any of Claims 1 to 8 in the context of an absolute pressure microphone.

## Revendications

1. Composant micromécanique muni d'un substrat (10) et d'une structure stratifiée sur le substrat (10), comprenant au minimum
- une membrane (1) qui recouvre au moins un espace creux (2) dans le substrat (10) et
- une couche de recouvrement rigide (16) qui est disposée au-dessus de la membrane (1) et espacée de celle-ci et qui possède au moins une ouverture d'accès (4) à la membrane (1) de sorte que la membrane (1) peut être soumise à une pression par le biais de l'ouverture d'accès (4) et peut être déviée par effet élastique perpendiculairement aux plans de la couche,
* au moins un élément de commutation (3) destiné à détecter les déviations de la membrane est formé dans la structure stratifiée de la membrane (1), et
* il existe un circuit de compensation muni d'au moins un élément actionneur (3, 7) pour la compensation des tensions mécaniques dans la membrane,
**caractérisé en ce que**
le circuit de compensation comprend au moins un élément piézoélectrique faisant office d'élément actionneur formé dans la structure stratifiée de la membrane.

2. Composant selon la revendication 1, **caractérisé en ce que** ledit élément actionneur (3) est également destiné à détecter les déviations de la membrane dans le cadre de l'acquisition de valeurs mesurées.

3. Composant selon l'une des revendications 1 à 2, **caractérisé en ce que** le circuit de compensation comprend au moins un élément de commutation avec lequel est réalisée une détection quantitative d'une pré-déviation de la membrane.

4. Composant selon l'une des revendications 1 à 3, **caractérisé en ce que** la structure stratifiée comprend une première couche conductrice (11) en un matériau semiconducteur monocristallin et **en ce qu'**au moins des parties du circuit d'interprétation et/ou du circuit de compensation sont intégrées dans cette première couche conductrice.

5. Composant selon l'une des revendications 1 à 4, **caractérisé en ce que** la structure stratifiée de la membrane comprend au moins un plan de pistes conductrices (13).

6. Composant selon la revendication 5, **caractérisé en ce que** l'au moins un élément piézoélectrique ou l'au moins une électrode de condensateur (3) est formé(e) dans le plan de pistes conductrices (13).

7. Composant selon l'une des revendications 1 à 6, **caractérisé en ce que** la couche de recouvrement rigide (16) est constituée d'un matériau semiconducteur conducteur.

8. Composant selon l'une des revendications 1 à 7, **caractérisé en ce qu'**au moins des parties du circuit d'interprétation et/ou du circuit de compensation sont intégrées dans la couche de recouvrement rigide (16).

9. Utilisation d'un composant micromécanique selon l'une des revendications 1 à 8 en tant qu'élément de détection d'un capteur de pression absolue.

10. Utilisation d'un composant micromécanique selon l'une des revendications 1 à 8 dans le cadre d'un microphone à pression absolue.
